(19) Europäisches Patentamt
European Patent Office
Office européen des brevets

(11) **EP 3 211 442 B1**

(12) **EUROPÄISCHE PATENTSCHRIFT**

(45) Veröffentlichungstag und Bekanntmachung des Hinweises auf die Patenterteilung:
**20.11.2019 Patentblatt 2019/47**

(51) Int Cl.:
**G01R 33/30** *(2006.01)* **G01B 7/30** *(2006.01)*
**G01D 5/14** *(2006.01)* *G01R 33/07* *(2006.01)*

(21) Anmeldenummer: **17157356.1**

(22) Anmeldetag: **22.02.2017**

(54) **MESSKOPF EINER NMR-MAS-APPARATUR MIT VORRICHTUNG ZUR BESTIMMUNG DES WINKELS ZWISCHEN MAS-ROTOR UND STATISCHEM MAGNETFELD**

MEASURING HEAD OF AN NMR MAS APPARATUS WITH A DEVICE FOR DETERMINING THE ANGLE BETWEEN MAS ROTOR AND STATIC MAGNETIC FIELD

TÊTE DE MESURE D'UN APPAREIL NMR MAS COMPRENANT UN DISPOSITIF DE DÉTERMINATION DE L'ANGLE ENTRE LE ROTOR MAS ET LE CHAMP MAGNÉTIQUE STATIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2016 DE 102016202943**

(43) Veröffentlichungstag der Anmeldung:
**30.08.2017 Patentblatt 2017/35**

(73) Patentinhaber: **Bruker Switzerland AG**
**8117 Fällanden (CH)**

(72) Erfinder: **Freytag, Nicolas**
**8122 Binz (CH)**

(74) Vertreter: **Kohler Schmid Möbus Patentanwälte**
**Partnerschaftsgesellschaft mbB**
**Gropiusplatz 10**
**70563 Stuttgart (DE)**

(56) Entgegenhaltungen:
**US-B2- 8 203 339**

**Beschreibung**

Die Erfindung betrifft einen Messkopf einer NMR (=Kernspinresonanz)-MAS (=magic angle spinning) Apparatur, der im Betrieb in ein Magnetsystem eingeführt ist, das ein homogenes statisches Magnetfeld $B_0$ in einer z-Richtung erzeugt, wobei sich im Betrieb der NMR-MAS-Apparatur im Messkopf eine NMR-Messprobe befindet, die eine Rotationsachse aufweist, wobei die Rotationsachse in Bezug auf die z-Achse um einen Winkel $\theta > 0$ geneigt ist, in einer xz-Ebene liegt, wobei der Winkel $\theta$ durch eine Drehung um eine Drehachse DA parallel zur y-Achse um einen Zielwinkel $\theta_{soll}$ herum verstellt werden kann, wobei $z = 0$ als der Schnittpunkt der Rotationsachse mit der z-Achse bei eingestelltem Winkel $\theta = \theta_{soll}$ definiert ist, und wobei der Messkopf eine Winkelmessapparatur mit einem ersten Sensorelement umfasst, die ein vom Winkel $\theta$ abhängiges Signal $S(\theta)$ erzeugt.

Ein solcher NMR-MAS Messkopf ist etwa bekannt aus US 8,203,339 B2.

Hintergrund der Erfindung

NMR-Spektroskopie ist ein Verfahren der instrumentellen Analytik, mit dem insbesondere die chemische Zusammensetzung von Messproben bestimmt werden kann. Dabei werden Hochfrequenz-Pulse in die Messprobe, die sich in einem starken, homogenen statischen Magnetfeld $B_0$ befindet, eingestrahlt, und die elektromagnetische Reaktion der Probe wird vermessen. Bei der Festkörper NMR-Spektroskopie ist es bekannt, zur Verringerung von Linienverbreiterungen aufgrund anisotroper Wechselwirkungen die Messprobe in einer Ausrichtung zum homogenen statischen Magnetfeld anzuordnen, die statt der herkömmlichen 0° oder 90° unter dem sogenannten "magischen Winkel" von $\theta_m$ = arccos($\sqrt{1/3}$) $\approx$ 54,74° geneigt ist. Diese Messtechnik wird üblicherweise als "magic-angle spinning" (MAS) bezeichnet. Der Winkel $\theta_m$ ist eine Lösung des zweite-Ordnung Legendrepolynoms $P_2(\cos(\theta_m)) = 0$, so dass alle Wechselwirkungen die von diesem Legendrepolynoms abhängen unter diesem Winkel zum Magnetfeld verschwinden. Dies ist der Fall für drei wichtige Wechselwirkungen in der Materie: der dipolaren Kopplung, der chemischen Shift Anisotropie und der Quadrupolwechselwirkung erster Ordnung. Da für nicht einkristalline Messproben die Kristallrichtungen einzelner Kristallite zufällig zum statischen Feld stehen wird die Auslöschung der Wechselwirkung durch eine ausreichend schnelle Rotation der Messprobe im magischen Winkel erzielt. Somit lässt sich eine Linienverbreiterung durch diese Wechselwirkungen signifikant reduzieren, im Idealfall sogar bis zur natürlichen Linienbreite.

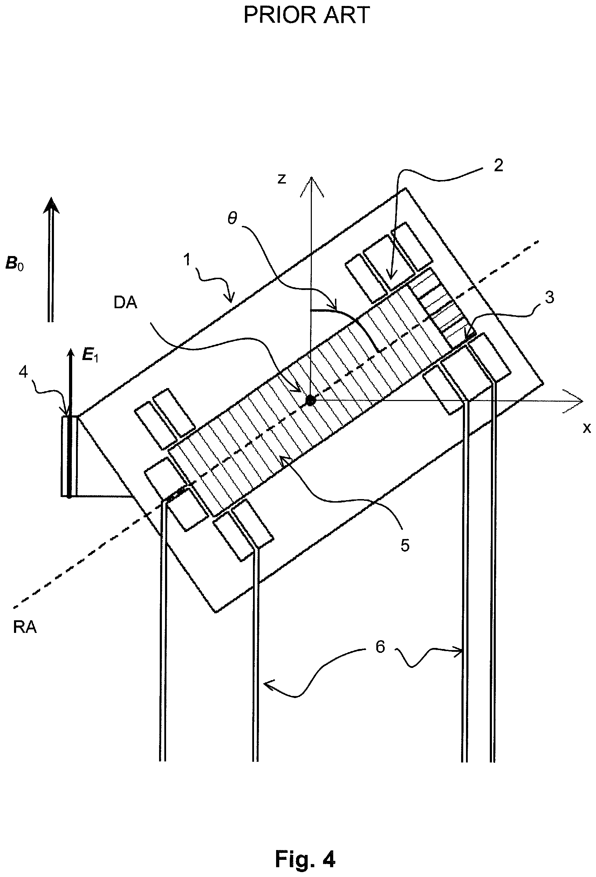

MAS-NMR-Messköpfe erlauben es hochauflösende NMR Spektroskopie mit festen, pulverförmigen oder semisoliden (gelförmigen oder pastösen) Messproben durchzuführen. Dabei wird - wie in Fig. 4 dargestellt - die Messprobe 5 in einen kreiszylinderförmigen Probenbehälter, den sogenannten Rotor gefüllt, der mittels komprimierter Gase in einem Stator 1 zu sehr hohen Drehzahlen mit einer Rotationsfrequenz im Bereich einiger kHz bis über hunderttausend kHz rotiert wird. Die radiale Lagerung wird durch Luftlager 2 im Stator sichergestellt ebenso wie eine durch Luftströmung erzeugte Haltekraft den Rotor in seiner axialen Position im Stator hält. Die Orientierung der Rotationsachse in Bezug auf das statische Magnetfeld wird durch den Stator vorgegeben.

Für viele NMR Experimente in Magnetsystemen mit $B_0$-Feldern im Bereich von 7 T bis 25 T ist eine Präzision der Einstellung des magischen Winkels von 0.1° bis 0.01° ausreichend, für einige Anwendungen wie z.B. satellite transition (STMAS) NMR oder die Protonenspektroskopie wird jedoch eine Präzision von bis zu 0.001° gefordert. Die Winkeleinstellung muss über einen weiten Temperaturbereich konstant bleiben sowie beim Wechsel der Messproben reproduzierbar gewährleistet sein. Dies stellt extrem hohe Anforderungen an die mechanischen Komponenten, wenn die Einstellung gesteuert statt geregelt erfolgen soll. Daher besteht der Wunsch nach einer Messapparatur, die zuverlässig den Winkel zwischen der Rotationsachse und dem statischen Magnetfeld misst.

Spezifischer Stand der Technik

In der Regel werden diese Messköpfe in supraleitenden NMR Magnetsystemen eingesetzt, bei denen das homogene statische Magnetfeld $B_0$ entlang einer "Bohrung" orientiert ist, die die z-Achse des Laborkoordinatensystems vorgibt. Alternativ können auch Magnetsysteme verwendet werden, bei denen das statische Magnetfeld orthogonal zu einer Bohrung des Magneten orientiert ist. Dies ist z.B. bei Permanentmagneten oder manchen supraleitenden Horizontalmagneten der Fall.

In Fig. 4 sind die Messprobe 5, die Rotationsachse RA und die Richtung des statischen Magnetfeldes im Schnitt dargestellt. Weiterhin sind die Luftlager 2, der Antrieb 3, die Drehachse DA, um die herum der Stator verdreht werden kann um den Winkel der Messprobe zum statischen Magnetfeld einzustellen, und die Luftzuleitungen 6 zur Bedruckung der Luftlager und des Antriebes dargestellt. Weitere Elemente des NMR Messkopfes wie HF-Spulen, Wandungen, Netzwerke etc sind der Einfachheit halber nicht dargestellt. Die Rotationsachse RA der Messprobe wird auch als z'-Achse bezeichnet und hat einen gemeinsamen Ursprung mit der z-Achse. Die z- und z'-Achsen liegen in einer Ebene, die durch die x- und z-Achsen sowie die x'- und z'- Achsen aufgespannt wird. Die y- und y'-Achsen der beiden Koordinatensysteme sind identisch.

MAS-Messköpfe beinhalten im Stand der Technik in der Regel einen Verstellmechanismus, der die präzise Einstellung des Winkels $\theta$ zwischen der Rotationsachse RA der Messprobe entlang z' und dem statischen Magnetfeld $B_0$ entlang z erlaubt. Ein solcher im Messkopf integrierter Verstellmechanismus wird als "interner" oder "integrierter" Mechanismus bezeichnet. Dabei wird in der Regel die Messprobe, der Stator, der die Lagerung und den Antrieb des Rotors beinhaltet und die HF-Spulen bewegt. Diese Bewegung wird durch Seilzüge, Spindeln und Zahnräder, Hebel mit Linearbewegungen oder ähnliche Mechanismen induziert und beinhaltet hauptsächlich eine Rotationsbewegung, im Allgemeinen aber auch Rotationsbewegungen kombiniert mit Linearbewegungen. Es sind Verstellmechanismen mit manueller und motorisierter Einstellung bekannt, insbesondere mit elektromotorischer Verstellung. Bei vielen Messköpfen im Stand der Technik, insbesondere solchen, die in sogenannten standard-bore-Magnetsystemen, i.e. Magnetsystemen mit einem Bohrungsdurchmesser von weniger als 60 mm, Anwendung finden kann die Verstellung des Winkels über einen sehr großen Bereich durchgeführt werden und dient auch zum leichteren Auswerfen der Messproben beim Probenwechsel. Es sind auch Messköpfe bekannt, bei denen der Messkopf als Ganzes gegenüber dem Magnetsystem verkippt wird um die Justierung des Winkels des Winkels $\theta$ zu bewerkstelligen.

Weiterhin ist aus der US 8,547,099 B2 ein NMR System mit einem Messkopf ohne Verstellmechanismus bekannt. Bei diesem NMR-System wird die Neigung der Rotationsachse (z'-Achse) gegenüber dem Messkopf und dem Magnetsystem konstant gehalten und die Richtung des statischen Magnetfeldes dadurch gedreht, dass mittels einer zusätzlichen elektromagnetischen Spule, die um die Messprobe herum angeordnet ist, ein Feld $B_1$ erzeugt wird, so dass der Winkel zwischen der z'-Achse und der Richtung der Linearkombination der $B_0$ und $B_1$ Felder dem magischen Winkel entspricht. Somit wird bei einem derart gestalteten Messkopf eine elektronische Drehung des Winkels $\theta$ durchgeführt.

Es ist bekannt, dass die Präzision der bekannten Verstellmechanismen insbesondere beim Wechsel der Probentemperatur, Aus- und Einbau des Messkopfes in das Magnetsystem und Messprobenwechsel häufig nicht ausreichend für anspruchsvolle NMR-Messungen ist. Dies gilt insbesondere für die Protonenspektroskopie und STMAS, bei denen Winkelfehler im Bereich einiger tausendstel Grad bereits zu merklichen Linienverbreiterungen in den gemessenen Spektren führen können.

Im Stand der Technik wird folgendes Verfahren zur Einstellung des Winkels $\theta$ zwischen der Rotationsachse des Samples und der Magnetfeldrichtung verwendet: In der Regel wird eine Messprobe (z.B. pulverförmiges Kaliumbromid) mit möglichst großer Abhängigkeit der Linienbreite vom eingestellten Winkel mittels des NMR Messkopfs vermessen und die Linienbreiten der zentralen Linie und Rotationsseitenbanden und/oder die Höhe der Linien und/oder das Verhältnis der Amplitude/Breite zwischen verschiedenen Linien ausgewertet. Alternativ kann auch eine Auswertung direkt auf dem Zeitbereichssignal erfolgen. Im Anschluss wird die Kalibrations-Messprobe ausgeworfen und eine eigentliche Messprobe mit der Messsubstanz in den Messkopf eingeführt und die Winkeleinstellung von der Kalibrationsmessung übernommen.

Dies führt in vielen Fällen zu Fehlern, insbesondere wenn ein Messkopfausbau aus dem Magnetsystem und oder ein Verkippen des Stators zum Auswurf des Rotors notwendig ist oder ein Temperaturwechsel zwischen Kalibration und Messung stattfindet.

MAS-Messköpfe weisen typischerweise in einen sehr weiten Temperierbereich für die Messproben auf. Am unteren Ende der Temperierskala finden sich Messköpfe, die bis -50 °C, -80 °C, -130 °C oder sogar für Temperaturen im kryogenen Bereich von 30 K bis 100 K spezifiziert sind. Bei den oberen Grenzwerten der Temperierung sind Temperaturen bis +80 °C, +150 °C oder im Falle von Spezialproben sogar weit darüber hinaus spezifiziert. Die Temperierung der Messproben wird in den meisten Fällen durch Temperiergas sichergestellt, wobei zum Teil auch die Luft der Lager und/oder die Antriebsluft temperiert wird.

Aufgrund der Kompaktheit der Konstruktion (die Messprobendurchmesser sind typischerweise im Bereich von 0.7 mm bis 4 mm) ist die Temperatur zumindest eines Teils des Kippmechanismus nahe an der Temperatur der Messproben. Die Wiederholbarkeit der Einstellung eines Winkels mit hoher Präzision und über einen weiten Temperaturbereich hinweg ist technisch extrem schwierig zu realisieren und führt zu hohen Kosten in der Herstellung der mechanischen Teile.

Aufgrund der Komplexität der Problematik den Winkel $\theta$ der Rotationsachse gegenüber der z-Achse präzise und wiederholbar einstellen zu können besteht der Wunsch einer geregelten statt der üblicherweise gesteuerten Einstellung mittels Kalibrationsexperiment aber ohne Rückkopplung des eingestellten Winkels. Im Stand der Technik sind drei verschiedene Konzepte bekannt, die eine Rückkopplung zwischen eingestelltem Winkel und gemessenem Winkel erlauben:

Aus US-A 5,760,586 ist ein MAS Messkopf bekannt, der eine automatische Verstellung des Winkels zwischen der Rotationsachse der Messprobe und dem statischen Feld beinhaltet. Eine Ausführungsform beinhaltet einen Magnetfeldsensor, insbesondere einen Hall-Effekt Sensor, zur Messung dieses Winkels. Bevorzugt wird der Hall-Effekt Sensor in einem inhomogenen Bereich des statischen Magnetfeldes montiert und durch eine Mechanik beim Verstellen des Winkels $\theta$ in letzterem so bewegt, dass eine Kalibrationskurve den eingestellten Winkel $\theta$ zur gemessenen Magnetfeldamplitude des Sensors in Bezug setzen kann.

Aus US 8,203,339 B2 ist ein MAS Messkopf bekannt, bei dem die Verstellung des Winkels zwischen der Rotationsachse und dem statischen Magnetfeld mittels eines Hall-Effekt-Sensors geregelt wird, der möglichst parallel zum statischen Feld ausgerichtet ist und dessen Ausgangssignal (Hall-Spannung) in einen Winkel umgerechnet wird. Ein solcher Hall-Sensor ist in Fig. 4 mit Bezugsziffer 4 dargestellt.

Aus "Optical alignment in magic-angle NMR", G. Bodenhausen et al., J. Magn. Reson., 48 (1982), pp. 143-147 und "Optical lever for monitoring of the magic angle", E. Mihaliuk, T. Gullion, J. Magn. Reson., 223, (2012), pp 46-50 ist die Methode bekannt die Position des vom Stator reflektierten Laserstrahls zu detektieren und daraus den Winkel der Rotationsachse gegenüber dem Magnetfeld zu bestimmen.

Das optische Verfahren ist eine indirekte Messung des Winkels. Das Signal ist nicht direkt vom Magnetfeld abhängig. Somit leidet es unter dem Nachteil, dass die mechanische Positionierung des Messkopfes relativ zum Magnetfeldsystem den gemessenen Winkel beeinflusst. Ein solches Verfahren ist daher ungeeignet eine Messgenauigkeit und Reproduzierbarkeit von 0.001° auch für den Fall des Ausbaus eines Messkopfes zu liefern.

Die Messung des Winkels mittels eines Hall-Sensors beruht auf dem Hall Effekt. Dieser Effekt tritt für stromdurchflossene Leiter in einem magnetischen Feld auf und führt zu einer Spannung senkrecht zum Stromfluss und Feldrichtung gemäß

$$U_{\mathrm{H}} = (A_{\mathrm{H}} \, I/d \,) \, B_{\perp}$$

Wobei $U_{\mathrm{H}}$ die Hall-Spannung, $A_{\mathrm{H}}$ der Hall Koeffizient, $I$ der Steuerstrom, $B_{\perp}$ die magnetische Flussdichte orthogonal zur Sensorebene und $d$ die Dicke des Leiters ist.

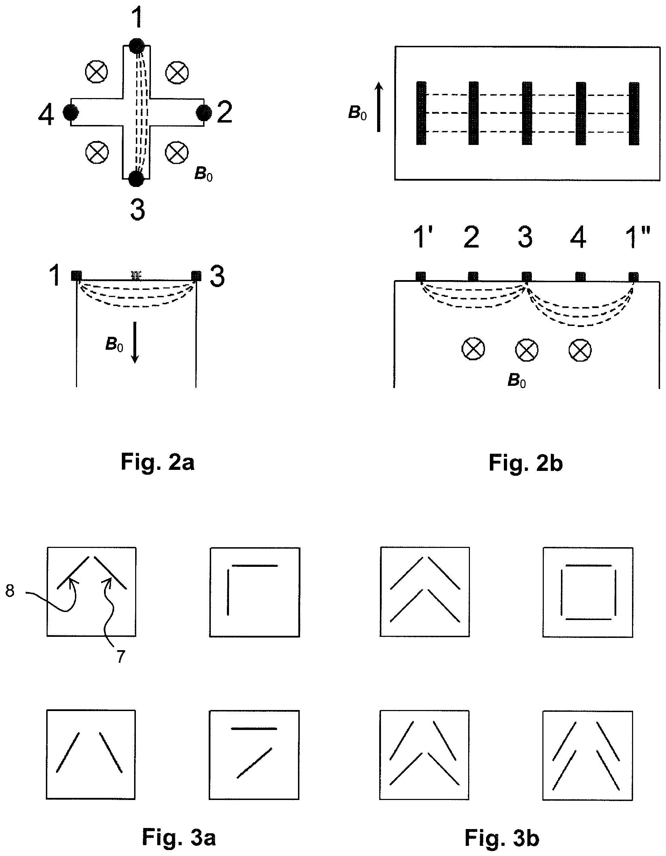

Fig. 2a zeigt eine Aufsicht-Zeichnung (oben) und einen Querschnitt (oben) eines ebenen Hall-Sensors, dessen Ebene orthogonal zum Magnetfeld steht. Die Kreuze in der Aufsichtsdarstellung symbolisieren die Richtung des statischen Magnetfeldes $B_0$. Der Hall-Sensor weist mindestens vier Kontakte (1-4) auf, wobei in der Darstellung zwischen den Kontakten 1 und 3 ein Strom fließt. Die Hallspannung wird durch die Umlenkung der Elektronen, deren Bahnen durch gestrichelte Linien symbolisiert sind, zwischen den Kontakten 2 und 4 aufgebaut.

Leider stellt sich der Hall Effekt in der Realität als weniger ideal dar, als diese Formel suggeriert: Der Hall-Koeffizient $A_{\mathrm{H}}$ hängt von der temperaturabhängigen Ladungsträgerdichte (Elektronen/ Löcher) und Beweglichkeit dieser Ladungsträger ab. Dadurch ergibt sich eine zum Teil ausgeprägte Temperaturabhängigkeit der Hallspannung. Dieser Temperaturabhängigkeit wird bei reellen Sensoren, zusätzlich noch eine weitere durch eine Kombination aus temperaturbedingtem mechanischem Stress und piezoelektrischem Effekt entstehende Spannung überlagert.

Neben der Temperaturabhängigkeit stellen sich auch Magnetfeldabhängige Effekte ein: da die Bandstruktur von Leitern sich im Magnetfeld in der Regel ändert führt dies zu Nichtlinearitäten des Hall-Effektes insbesondere in starken Magnetfeldern.

Weiterhin generieren Hall-Sensoren in der Regel eine Offset-Spannung im Nullfeld, die z.B. durch leichte Asymmetrien der Kontakte und/oder Positionierung des Sensors in Bezug auf die Kristallachsen des verwendeten Substrates auftritt. Weiterhin weisen sie Alterungserscheinungen auf, die zu Langzeit-Driften führen können. Auch Thermospannungen in den Zuleitungen und Kontakten führen zu temperaturabhängigen Fehlern bei ungeeignetem Messaufbau.

Darüber hinaus treten weitere magnetoresistive Effekte auf, von denen insbesondere der Planare Hall Effekt (PHE) für eine Anwendung zur Winkeldetektion problematisch sein kann: Bei diesem Effekt tritt eine Spannung

$$U_{\mathrm{PHE}} = (A_{\mathrm{PHE}} \, I/d \,) \, B_{\parallel}^{2} \, \sin(2\varphi)$$

auf, wobei $\varphi$ der Winkel zwischen der Projektion des Magnetfeldes in die Sensorebene und dem Steuerstrom ist. Auch $A_{\mathrm{PHE}}$ ist nur in erster Näherung konstant.

Wird ein Hall-Sensor einem magnetischen Feld ausgesetzt, das nicht orthogonal zur Sensorebene steht, dann ist das Ausgangssignal die Summe der Hall-Spannung und der planaren Hall Spannung.

$$U = (A_{\mathrm{H}} \, I/d \,) \, B_{\perp} + (A_{\mathrm{PHE}} \, I/d \,) \, B_{\parallel}^{2} \, \sin(2\varphi)$$

Weiterhin können noch spin-abhängige Streuprozesse auftreten (anormaler Hall Effekt), bei Betrieb bei kryogenen Temperaturen auch noch Shubnikov-de Haas und Quanten-Hall Effekt.

Für Präzisionsmessungen ist daher eine sorgfältige Kalibration über den gesamten Einsatzbereich (Magnetfeldstärke, Winkel und Temperatur) notwendig, die, um Alterungseffekte zu korrigieren, regelmäßig wiederholt werden muss. Des Weiteren ist es wünschenswert nur Sensoren einzusetzen, bei denen die Offsetspannungen bauartbedingt bereits soweit wie möglich reduziert sind und "Störeffekte" wie der PHE möglichst gering ausfallen. Es ist beispielsweise bekannt, dass ein auf einer Heterojunction basierender Hall-Sensor einen bis zu fünfzig Mal geringeren PHE aufweist als ein vergleichbarer Hall-Sensor aus demselben, jedoch kontinuierlich dotierten Halbleiter.

Bei den aus dem Stand der Technik bekannten Verfahren zur Bestimmung und Einstellung des magischen Winkels von NMR Messköpfen mit Hilfe einer Magnetfeldmessung basiert auf zwei verschiedenen Prinzipien: In US 8,203,339 B2 wird ein Hall-Sensor so im statischen Magnetfeld montiert, dass die Sensorebene und damit der Empfindlichkeitsvektor möglichst parallel, d.h. unter einem Winkel kleiner als 5°, zu diesem steht. Die ausgelesene Hall-Spannung wird im Anschluss in einen Winkel umgerechnet und zur Einstellung des Winkels genutzt.

Problematisch bei diesem Ansatz sind mehrere Punkte:

1. Bei Orientierung des Sensors parallel zum Feld wird dieser in einem Bereich betrieben, in dem der PHE zu vergleichbaren oder sogar höheren Spannungen als der normale Hall Effekt führen kann. Damit ist die Winkelmessung nicht mehr in erster Linie von der orthogonalen Komponente des Magnetfeldes sondern vom Winkel des Stromes zur parallelen Komponente des Feldes abhängig.

2. Die Einstellung des Winkels hängt direkt von der Genauigkeit der Messung der Hall-Spannungen und des Messstromes ab.

3. Jegliche Drift und veränderte Hall-Koeffizienten (Temperaturabhängigkeit) führen zu Winkelfehlern, es sei denn der Winkel des Sensors wird auf exakt 0° justiert.

Das aus US-A 5,760,586 nutzt ebenfalls einen Hall-Sensor als Magnetfeldsensor, der jedoch in einem inhomogenen Bereich des Magnetfeldes platziert wird. Eine Rotationsbewegung des Stators, der die Rotationsachse der Messprobe definiert, wird über eine Mechanik in eine Translation des Sensors im inhomogenen Feld übersetzt. Die ausgelesene Hallspannung wird über eine Kalibrationstabelle in einen Winkel umgerechnet und zur Einstellung desselben genutzt.

Problematisch ist bei diesem Ansatz:

1. Eine Positionsungenauigkeit entlang der z-Achse führt zu Winkelfehlern. Diese Ungenauigkeit kann z.B. dann auftreten, wenn der Messkopf gegenüber einem Shimsystem in seiner Position referenziert wird, dieses jedoch aufgrund von Temperaturschwankungen seine Länge in Bezug auf den Befestigungspunkt am Magneten ändert.

2. Die inhomogenen Felder hängen von den eingestellten Strömen des Shimsystems ab. Auch Fluktuationen der Shimfelder aufgrund der Fluktuationen der Shimstromquellen werden direkt in Fluktuationen des gemessenen Winkels übertragen.

3. Die Einstellung des Winkels hängt direkt von der Genauigkeit der Messung der Hall-Spannungen und des Messstromes ab.

4. Jegliche Drift und veränderte Hall-Koeffizienten (Temperaturabhängigkeit) führen zu Winkelfehlern

Aufgabe der Erfindung

Der vorliegenden Erfindung liegt die Aufgabe zugrunde, einen NMR-MAS-Messkopf der eingangs definierten Art zur Verfügung zu stellen, der es erlaubt, kostengünstig und mit einfachen, ohne Weiteres zur Verfügung stehenden technischen Mitteln den Winkel $\theta$ zwischen der Rotationsachse und der z-Achse über einen möglichst großen Bereich mit hoher Präzision und Reproduzierbarkeit zu messen und dadurch ein Rückkopplungssignal für eine geregelte Einstellung des Winkels $\theta$ auszugeben.

Beschreibung der Erfindung

Das im Stand der Technik bestehende Problem der Fehleranfälligkeit der Justierung des magischen Winkels von MAS-Messköpfen von Unzulänglichkeiten der verwendeten Messelemente kann auf überraschend einfache und effektive Art und Weise und mit jederzeit zur Verfügung stehenden technischen Mitteln dadurch gelöst werden, dass die Winkelmessapparatur mindestens ein zweites Sensorelement umfasst, wobei für die Anzahl $i$ der Sensorelemente gilt $i \geq 2$, und wobei die Sensorelemente jeweils ein Sensorsignal $Ti(\boldsymbol{E}_i, \boldsymbol{B}_0)$ erzeugen, das von der Amplitude $B_0$ des statischen Magnetfeldes $\boldsymbol{B}_0$ und der vektoriellen Orientierung zwischen dem Magnetfeld $\boldsymbol{B}_0$ und mindestens einem Empfindlichkeitsvektor $\boldsymbol{E}_i$ abhängt, wobei die Emfpindlichkeitsvektoren $\boldsymbol{E}_i$ so orientiert sind, dass sie beim größtmöglichen Signal $T_i^{max}$ orthogonal zum Magnetfeld $\boldsymbol{B}_0$ orientiert sind, und wobei das vom Winkel $\theta$ abhängige Signal $S(\theta)$ eine Funktion $f(T_i)$ der mindestens zwei Sensorsignale $T_i(\boldsymbol{E}_i, \boldsymbol{B}_0)$ ist, dass mindestens zwei Empfindlichkeitsvektoren $\boldsymbol{E}_i$ einen Winkel $\alpha_i$ zur z-Achse aufweisen und für die Winkel $\alpha_i$ gilt $5° < \alpha_i < 175°$, und dass mindestens zwei der Empfindlichkeitsvektoren $\boldsymbol{E}_i$ einen Winkel $\beta$ zueinander aufweisen für den gilt $\beta > 10°$.

Der erfindungsgemäße Messkopf umfasst also mindestens zwei Magnetfeld-Messelemente, von denen mindestens zwei jeweils einen Winkel größer 5° zum statischen Feld und einen Winkel zueinander von mehr als 10° aufweisen und zur Bestimmung des Winkels ein kombiniertes Signal der gemessenen Sensorsignale verwendet wird.

Zunächst soll aber zum besseren Verständnis die bisher übliche Technik erläutert werden, die von der Erfindung nunmehr verbessert wird:

Wie bereits oben dargestellt, ist die präzise Einstellung des Winkels $\theta$ zwischen der Rotationsachse einer Messprobe und der Richtung des statischen Magnetfeldes $\boldsymbol{B}_0$ in einem MAS-Messkopf ohne geregelte Feedbackschleife nicht oder nur mit sehr hohen Kosten für Präzisionsmechanik und Kalibration möglich. Es sind Messköpfe bekannt, die einen Sensor beinhalten um diesen Winkel zu messen, von denen diejenigen mit einem Hall-Sensor, dessen Sensorebene möglichst parallel zum statischen Magnetfeld im homogenen Bereich montiert ist die vielversprechendste Lösung darstellen. Jedoch ermöglichen auch diese Messköpfe keinen längerfristigen Betrieb ohne Rekalibration, insbesondere auch keine variable Temperatur der Messproben.

Sensoren, die zur Messung eines Winkels in Bezug auf das statische Magnetfeld eines Magneten eingesetzt werden können, können durch einen Empfindlichkeitsvektor $\boldsymbol{E}$ charakterisiert werden. In der Folge geben diese Sensoren ein Signal $T(\boldsymbol{E}, \boldsymbol{B}_0)$, das von der Amplitude $B_0$ des statischen Magnetfeldes, und der vektoriellen Orientierung zwischen dem Magnetfeld $\boldsymbol{B}_0$ und einem Empfindlichkeitsvektor $\boldsymbol{E}$ abhängt, wobei der Empfindlichkeitsvektor $\boldsymbol{E}$ so definiert ist, dass der Sensor beim größtmöglichen Signal $T^{max}$ orthogonal zum Magnetfeld $\boldsymbol{B}_0$ orientiert sind.

Für einen Hall-Sensor, dessen Signal $T \sim U_H = (A_H I/d) B_\perp$ für $B_\perp = B_0$ maximal ist steht der Empfindlichkeitsvektor folglich orthogonal zur Richtung der Flächennormalen der Sensorebene und in der durch das Magnetfeld und der Flächennormalen aufgespannten Ebene.

Daher ist die Empfindlichkeit des Messsignals $T(\boldsymbol{E}, \boldsymbol{B}_0)$ auf eine Winkeländerung, i.e. die Ableitung des Messsignals gegen den Winkel zwischen $\boldsymbol{E}$ und $\boldsymbol{B}_0$ am größten, wenn ein Hall-Sensor möglichst parallel zum statischen Magnetfeld montiert wird.

Für einen auf dem PHE basierenden Sensor hingegen ist das Signal $T \sim U_{PHE} = (A_{PHE}\, I/d)\, B_\parallel^2 \sin(2\varphi)$. In diesem Falle gibt es zwei Lösungen, die zu $T^{max}$ führen. Im Sinne der Erfindung soll von den möglichen äquivalenten Lösungen eine beliebige zur Definition des Empfindlichkeitsvektors ausgewählt werden. Die Definition des Empfindlichkeitsvektors ist im Rahmen der Erfindung auch unabhängig von der Ansteuerung definiert. So findet man z.B. bei einer Lock-in-Detektion für einen Hall-Sensor zwei äquivalente Lösungen mit entgegengesetzter Vektorrichtung, von denen eine als Empfindlichkeitsvektor ausgewählt wird.

Ein großer Nachteil von Hall-Sensoren ist ihre üblicherweise große Offset-Spannung, d.h. ein Ausgangssignal, das auch im Nullfeld auftritt. Eine aus dem Stand der Technik bekannte sehr effiziente Methode um solche Offset-Spannungen zu eliminieren bzw. zu reduzieren ist die sogenannte Spinning-Current Detektion, bei der die Steuerstrom und Spannungselektroden des Hall-Sensors periodisch vertauscht werden. Das Spinning-Current-Verfahren besteht darin, die Messrichtung an einem Hall-Sensor mit mindestens $N$ Kontakten ständig mit einer Taktfrequenz, typischerweise im kHz Bereich, um einen Winkel $\varphi = 360°/N$ zyklisch weiter zu drehen und über alle Messsignale einer vollen Drehung um 360° zu summieren. Bei einem lateralen Hall-Sensor mit vier Elektroden, von denen sich jeweils zwei gegenüber liegen, wird daher jede der Elektroden im Wechsel der Spinning-Current-Phasen als Steuerstrom-Elektrode und als Mess-Elektrode zur Bestimmung der Hall-Spannung genutzt. In einer Phase bzw. einem Zyklus fließt der Steuerstrom von einer ersten Elektrode zu der gegenüber liegenden dritten Elektrode, wobei die Hall-Spannung an den orthogonal positionierten Elektroden zwei und vier abgegriffen wird. Beim nächsten Zyklus wird die Messrichtung um 90° verdreht, so dass die Elektroden, die im vorangehenden Zyklus zur Messung der Hall-Spannung eingesetzt wurden, zur Stromeinspeisung dienen. Durch die Summation über alle vier Zyklen bzw. Phasen heben sich die Offset-Spannungen annähernd gegenseitig auf, so dass nur die tatsächlich magnetfeldabhängigen Anteile des Signals übrig bleiben. Voraussetzung hierfür ist jedoch eine möglichst symmetrische Anordnung der Kontaktelektroden.

Dabei kann durch eine 2-Phasen Methode eine lineare Komponente des Offsets unterdrückt werden. Eine 4-Phasenmetode kann auch quadratische Terme sowie thermoelektrische Effekte eliminieren. Noch höhere Ordnungen führen zu weiteren Reduktionen von Offsetspannungen. Ein weiterer Vorteil der Spinning-Current Detektion ist die Reduktion des $1/f$-Rauschens.

Aus der US-A 4,782,375 sind Sensoren bekannt, die für Magnetfeld-Komponenten in den beiden Raumrichtungen orthogonal zur Substratoberfläche empfindlich sind. Für die Realisierung dieser so genannten vertikalen Hall-Sensoren sind Lösungen bekannt, die den Einsatz von Standard-Halbleitertechnologien zu deren Herstellung ermöglichen. Bei solchen vertikalen Hall-Sensoren, die durch konforme Abbildung aus bekannten Geometrien lateraler Hall-Sensoren erhalten wird, erstreckt sich ein elektrisch leitfähiges Gebiet annähernd senkrecht zur Oberfläche eines Substrates in dieses hinein, wobei sämtliche Anschlussbereiche entlang einer Seitenfläche des elektrisch leitfähigen Gebietes an der Oberfläche des Substrates liegen. Fig. 2b zeigt schematisch den Aufbau dieses vertikalen Hall-Sensors., wobei ähnlich wie beim ebenen Hall-Sensor eine Aufsicht-Zeichnung (oben) und einen Querschnitt (unten) dargestellt sind. Auch hier symbolisieren die Kreuze in der Querschnittsdarstellung die Richtung des statischen Magnetfeldes $B_0$.

Der Hall-Sensor weist mindestens fünf Kontakte (1', 1", 2-4) auf, wobei in der Darstellung zwischen den Kontakten 1' und 3 sowie zwischen 1" und 3 ein Strom fließt. Die Hallspannung wird durch die Umlenkung der Elektronen im Magnetfeld, deren Bahnen durch gestrichelte Linien symbolisiert sind, zwischen den Kontakten 2 und 4 aufgebaut.

Vertikale Hall-Sensoren bieten den großen Vorteil, dass mehrere Sensoren mit beliebigen Winkeln zueinander realisiert werden können, die in einem Arbeitsschritt auf ein und demselben Halbleitersubstrat gefertigt werden können. Dadurch weisen diese Sensoren sehr große Ähnlichkeit, z.B. in Bezug auf die Ladungsträgerdichte auf und verhalten sich bezüglich Temperaturschwankungen, Alterung, Stress, etc. sehr ähnlich. Wird ein Substrat aus gut wärmeleitendem Material wie z.B. Silizium gefertigt, kann durch die geringen Abstände zwischen zwei vertikalen Hall-Sensoren sichergestellt werden, dass beide Sensoren identische Temperaturen aufweisen und somit temperaturabhängige Effekte sich weitestgehend identisch auf beide Sensorelemente auswirken.

Fig. 3a zeigt vier mögliche Implementationen von vertikalen Hall-Sensoren auf einem Substrat. Dabei soll das Substrat stets eine feste Orientierung in Bezug auf die Kristallrichtung haben und lediglich die Platzierung der vertikalen Hall-Sensoren, die durch Linien symbolisiert sind verändert werden. Die oberen beiden Varianten weisen je zwei Sensoren auf, die untern 90° zueinander stehen. Je nach Orientierung des Gitters des Substrates kann eine der Varianten so beschaffen sein, dass beide Sensoren äquivalent sind und somit nahezu identische Eigenschaften aufweisen. In der unteren Reihe sind Sensoren mit beliebigen Winkeln und Orientierung zum Substrat dargestellt.

Erfindungsgemäß werden die Probleme der MAS-Messköpfe mit Winkelsensoren im Stand der Technik dadurch gelöst, dass der MAS-Messkopf so gestaltet ist, dass er anstelle des bislang einzigen Sensors mindestens zwei Sensoren 7,8 beinhaltet, die jeweils einen Winkel > 5° zur z-Achse und einen Winkel > 10° zueinander aufweisen und ein aus den Signalen der mindestens zwei Sensoren kombiniertes Signal zur Bestimmung des Winkel genutzt wird.

Werden beispielsweise zwei Hall-Sensoren so montiert, dass ihre Sensitivitätsvektoren bei eingestelltem Winkel $\theta = \theta_{soll}$ jeweils einen Winkel von $\alpha_{1,2} = 45°$ zur z-Achse und einen Winkel von $\beta = 90°$ gegeneinander aufweisen, so ist bei weitestgehend gleichem Steuerstrom $I^i$ und weitestgehend gleichen Hall-Sensoren eine weitestgehend identische Ausgangsamplitude der einzelnen Sensoren zu erwarten:

$$U_{\mathrm{H}}^i = \left(A_{\mathrm{H}}^i \left(T^i\right) I^i / d^i\right) B_\perp \text{ mit } B_\perp = B_0 \sin 45° = B_0 \sqrt{2}/2,$$

i.e.

$$U_{\mathrm{H}}^1 \approx U_{\mathrm{H}}^2 \text{ falls } A_{\mathrm{H}}^1(T) \approx A_{\mathrm{H}}^2(T) \text{ und } T^1 \approx T^2 \text{ sowie } I^1 \approx I^2$$

Beruht die Leitung im Hall-Sensor auf Elektronen und Löchern, so ist der HallKoeffizient

$$A_{\mathrm{H}} = \frac{n_e \mu_e^2 - n_p \mu_p^2}{e(n_e \mu_e + n_p \mu_p)^2}$$

Da bei Eigenhalbleitern die Beweglichkeit der Elektronen in der Regel viel größer ist als die der Löcher vereinfacht sich dies zu $A_{\mathrm{H}} \approx \frac{1}{e\, n_e}$.

Die Ladungsträgerdichte $n(T)$ ist von der Temperatur abhängig. Bei nichtentarteten Halbleitern mit Gap $\Delta E \gg k_B T$ lässt sich die im Metall für die Beschreibung der Elektronen erforderliche Fermi-Verteilung durch die Boltzmann-Verteilung ersetzen und man erhält

$$n(T) \sim T^{2/3}\, e^{-\Delta E / 2k_B T} \approx T^{2/3}(1 - \Delta E / (2k_B T))$$

Wird nun anstelle eines einzigen Sensorsignals das Verhältnis zweier Sensorsignale gemessen, wobei beide Sensoren die Temperatur T aufweisen, und aus demselben Halbleitermaterial gefertigt sind, so verhält sich das resultierende Signal $S(T)$ wie

$$S(T) \sim \frac{A_H^1(T)}{A_H^2(T)} = \frac{n_e^2(T)}{n_e^1(T)} \sim \frac{T^{2/3}\ e^{-\Delta E/2k_B T}}{T^{2/3}\ e^{-\Delta E/2k_B T}} = \text{const}$$

Somit ermöglicht die Verwendung eines aus dem Quotientenwert zweier Messelemente generierte Signal $S$ als Regelparameter die Temperaturabhängigkeit der Ladungsträgerdichte und somit des Halleffektes ohne Kalibration zu eliminieren. Da auch die Alterung eines Sensors sich in erster Linie auf die Ladungsträgerdichte auswirkt ist ein derart gestaltetes kombiniertes Messelement langzeitstabil und verändert sein Ausgangssignal nicht. Wird der Steuerstrom beider Sensoren aus einer einzigen Stromquelle erzeugt ist ein weiterer Vorzug der Methode, dass Rauschen des Steuerstroms durch die Verhältnisbildung ebenfalls eliminiert wird und somit eine ultra-präzise Stromregelung zur genauen Bestimmung des Winkels nicht notwendig ist.

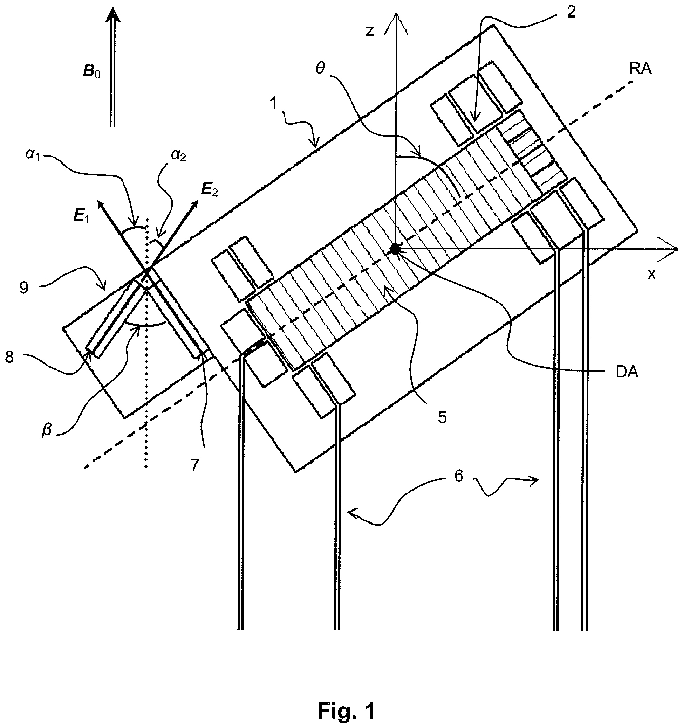

Ein solcher MAS Messkopf ist schematisch in Fig. 1 dargestellt, wobei neben der Messprobe 5, der Rotationsachse RA und der Richtung des statischen Magnetfeldes auch die Luftlager 2, der Antrieb 3, die Drehachse DA, um die herum der Stator verdreht werden kann um den Winkel der Messprobe zum statischen Magnetfeld einzustellen, und die Luftzuleitungen 6 zur Bedruckung der Luftlager und des Antriebes dargestellt sind. Weitere Elemente des NMR Messkopfes wie HF-Spulen, Wandungen, Netzwerke etc sind der Einfachheit halber nicht dargestellt.

In dieser Ausführungsform sind zwei Sensoren 7 und 8 dargestellt, wobei Sensor 7 in dieser konkreten Ausführungsform orthogonal zur Rotationsachse montiert ist und die beiden Sensoren und somit auch ihre Empfindlichkeitsvektoren denselben Absolutwert des Winkels in Bezug auf das statische Magnetfeld aufweisen.

Darüber hinaus ist bei Verwendung von verschiedenen Winkeln $\alpha_1 \neq \alpha_2$ der Empfindlichkeitsvektoren zweier Sensoren gegenüber dem Magnetfeld $\boldsymbol{B_0}$, respektive der $z$-Achse in Kombination mit verschiedenen Steuerströmen $I^1 \neq I^2$ die Möglichkeit gegeben verschiedenartige Sensoren zumindest über einen gewissen Bereich weitestgehend gleichläufig, d.h. mit weitestgehend identischen Signalen $T^i(\theta)$ zu betreiben, so dass eine präzise Messung des Winkels zumindest innerhalb eines bestimmten Winkelverstellbereichs für den Winkel $\theta$ möglich ist. Werden die Steuerströme durch Attenuation aus einem einzigen Steuerstrom gebildet, so trägt lediglich das Rauschen des Attenuationselementes zum Rauschen des Ausgangssignals bei, nicht jedoch das Rauschen des ursprünglichen Steuerstromes.

In einer anderen Situation, bei der beispielsweise der PHE als wesentlicher Anteil der Abweichungen des Messelementes von einem idealen Messelement identifiziert wird gilt für jeden Sensor

$$U^i = \left( A_H^i\, I/d \right) B_\perp + \left( A_{PHE}^i\ I/d \right) B_\parallel^2\, \sin(2\varphi)\,.$$

Für eine geschickte Anordnung der Sensoren gilt dann für das als Summe (bzw. Differenz) kombinierte Signal zweier Sensoren $S(\varphi) = 0$, d.h. die durch den Planaren-Hall-Effekt generierten Offsetspannungen können durch eine Addition/Subtraktion zweier Spannungen ausgelöscht werden. Die Summation/Subtraktion zweier Signale kann auch dazu beitragen andere additive Störeffekte zu eliminieren.

Bei Verwendung von mehr als zwei Sensorelementen können durch eine Kombination von Summation/Subtraktion und Division mehrere Parameter eliminiert werden. Dies ermöglicht es eine von externen Parametern weitestgehend unabhängige und langzeitstabile Messung zur Bestimmung des Winkels $\theta$ in einem MAS-Messkopf.

Fig. 3b zeigt vier mögliche Implementationen von vier vertikalen Hall-Sensoren auf einem Substrat. Dabei soll das Substrat stets eine feste Orientierung in Bezug auf die Kristallrichtung haben und lediglich die Platzierung der vertikalen Hall-Sensoren, die durch Linien symbolisiert sind verändert werden. Die oberen beiden Varianten weisen je zwei mal zwei identisch orientierte Sensoren auf, die untern 90° zueinander stehen. In der unteren Reihe sind vier Sensoren mit verschiedenen, bzw. paarweise verschiedenen Winkeln und Orientierung zum Substrat dargestellt.

Bevorzugte Ausführungsformen und Weiterbildungen der Erfindung

Bei besonders bevorzugten Ausführungsformen des erfindungsgemäßen Messkopfs gilt für die Winkel $\alpha_i$: 30° $< \alpha_i < 60°$ $\forall i$, vorzugsweise $\alpha_i \approx 45°$. Bevorzugt werden zwei Sensoren unter jeweils 45° zum statischen Magnetfeld montiert. Daraus resultiert ein Winkel von 90° zueinander. Werden identische Messelemente mit $|\alpha_i| = |\alpha_j|$ verwendet so ist das Ausgangssignal beider Sensoren bei dieser Positionierung gleich und die Messempfindlichkeit beider Sensoren ist identisch.

Bei anderen bevorzugten Ausführungsformen werden die beiden Sensoren derart montiert, dass die Empfindlichkeitsvektoren $\boldsymbol{E_i}$ jeweils unter einem Winkel < 45°, besser < 20°, noch besser < 10° zum statischen Magnetfeld ausgerichtet sind. Auf diese Art und Weise wird die Empfindlichkeit beider Sensoren auf Winkeländerungen maximiert.

Um eine hohe Präzision der Messung erreichen zu können muss jedoch in diesem Falle eine sehr gute Kompensation der Offsetspannungen vorgesehen werden.

Bevorzugt sind auch Ausführungsformen des erfindungsgemäßen Messkopfs, die sich dadurch auszeichnen, dass eine Vorrichtung zur automatisierten Einstellung des Winkels $\theta$ aufgrund der $i$ Sensorsignale $T_i(\boldsymbol{E}_i, \boldsymbol{B}_0)$ vorhanden ist. Dies erlaubt insbesondere im Zusammenspiel mit Robotern für den Wechsel von Messproben einen voll automatisierten Betrieb des NMR Spektrometers auch in Abwesenheit eines Nutzers und somit eine höhere Auslastung der Spektrometer-Hardware. Dadurch können für Nutzer die Kosten dieser Analytikmethode gesenkt werden.

Weitere vorteilhafte Ausführungsformen der Erfindung sind dadurch gekennzeichnet, dass mindestens zwei Gruppen von mindestens zwei Sensoren so verschaltet werden, dass die Summe der Verhältnisse der Messsignale oder das Verhältnis der Summen der Sensoren innerhalb jeder Gruppe der mindestens zwei Gruppen als Regelsignal zur Einstellung oder Nachführung des Winkels $\theta$ erhalten wird. Durch die Kombination von Summation und Quotientenbildung können sowohl additive als auch multiplikative Abhängigkeiten des Messsignals von externen Parametern eliminiert werden. Dadurch kann ein langzeitstabiles, temperaturunabhängiges Signal zur geregelten Einstellung oder Nachführung des magischen Winkels zur Verfügung gestellt werden und hochpräzise Winkeleinstellung ermöglicht werden. Eine Nachführung des Winkels erlaubt es mechanische Komponenten preiswerter auszuführen und stattdessen mittels geregelter Kompensationsmechanismen die Winkeleinstellung langfristig konstant zu halten. Dadurch werden Langzeitmessungen auf kosteneffiziente Art und Weise möglich.

Bei einer weiteren besonders bevorzugten Ausführungsform werden die mindestens zwei Messelemente - in der Regel gleichzeitig - auf einem gemeinsamen Substrat oder Träger gefertigt. Dies führt zu einem möglichst identischen Temperaturabhängigkeiten und Alterungsverhalten. Dadurch kann die Fehlertoleranz des Messverfahrens erhöht werden.

Dies ist insbesondere bei der Verwendung von Hall-Sensoren des Typs vertikaler Hall-Sensor von Vorteil, da die mindestens zwei Sensoren in einem Arbeitsschritt auf einem einzigen Substrat gefertigt werden können und somit vergleichbare Eigenschaften aufweisen. Darüber hinaus kann davon ausgegangen werden, dass die Temperatur der beiden Sensoren identisch ist, zumindest dann, wenn das Substrat eine hohe Wärmeleitfähigkeit aufweist. Daher weisen bei bevorzugten Ausführungsformen der Erfindung zumindest einige der Sensorelemente, vorzugsweise Weise sämtliche Sensorelemente, Hall-Sensoren auf. Diese Sensoren sind insbesondere für starke Magnetfelder und Präzisionsmessungen von Vorteil. Bei Verwendung anderer Typen von Magnetfeldsensoren kann darauf geachtet werden, dass Sensoren aus ein und demselben Produktionsbatch, idealerweise ebenfalls auf ein und demselben Substrat zeitgleich gefertigte Sensoren verbaut werden. In diesem Fall ist auch davon auszugehen, dass die Langzeitstabilität des kombinierten Signals gegeben ist. Bei Verwendung physisch getrennter Sensoren muss bei der Montage besonderes Augenmerk auf eine enge thermische Kopplung gelegt werden, um identische Temperaturen in allen Sensoren sicherzustellen.

Bei einer bevorzugten Ausführungsform mit Hall-Sensoren wird eine AC- oder Lock-in-Messung durchgeführt. Dies dient der Kompensation von Offset-Spannungen.

Bei einer weiteren besonders bevorzugten Ausführungsform mit Hall-Sensoren, werden die Hall-Sensoren mittels Spinning-Current Methode ausgelesen. Dabei werden mindestens 2 Phasen (zweifach orthogonales Schalten), besser 4 oder 8 Phasen Spinning-Current-Messungen verwendet. Dadurch werden diverse Offsetspannungen effizient unterdrückt und das Rauschen minimiert.

Bei einer anderen vorteilhaften Ausführungsform werden die mindestens zwei Sensoren durch eine Verbindung mit hoher Wärmeleitfähigkeit auf dem Stator befestigt, der aus Material mit hoher Wärmeleitfähigkeit $\lambda_S$ gefertigt ist. Dadurch kann sichergestellt werden, dass der gemessene Winkel auch bei Änderungen der Messprobentemperierung schnell korrekte Werte anzeigt und keine langsamen Driften aufgrund thermischer Effekte in den Halterungen auftreten. Da der Stator die Richtung der Rotationsachse RA über die Radiallagerungen 2 des Rotors, in dem sich die Messprobe 5 befindet definiert werden somit Winkeleinflüsse des Regelsignals $S$ auf Temperaturgradienten minimiert.

Für die Wärmeleitfähigkeit $\lambda_S$ gilt dabei $\lambda_S > 30 \,\text{W/(m K)}$, besser $\lambda_S > 100 \,\text{W/(m K)}$, idealerweise $\lambda_S > 200 \,\text{W/(m K)}$

Bei einer anderen bevorzugten Ausführungsform werden Magnetodioden oder Magnetotransistoren als Sensorelemente eingesetzt. Diese Sensoren sind besonders günstig in der Herstellung und Integration in eine Messelektronik.

Bei weiteren bevorzugten Ausführungsformen der Erfindung sind drei oder mehr Sensorelemente vorhanden, also $i \geq 3$, wobei die Sensorelemente bevorzugt identisch ausgeführt sind. Dabei können die Emfpindlichkeitsvektoren $\boldsymbol{E}_i$ der Sensoren zum Teil identisch sein. Durch die Verwendung einer größeren Anzahl von Sensoren kann z.B. das Rauschen und Offsetspannungen durch Mittelung verbessert werden.

Bei einer bevorzugten Ausführungsform werden jeweils mindestens zwei Sensorelemente mit demselben Empfindlichkeitsvektor $\boldsymbol{E}_i$ montiert. Durch orthogonale Kopplung dieser beiden Sensoren können Offset-Effekte und PHE in der Regel um mindestens eine Größenordnung reduziert werden.

In den Rahmen der vorliegenden Erfindung fällt auch ein NMR-Spektrometer mit einem Magnetsystem, das ein homogenes statisches Magnetfeld $\boldsymbol{B}_0$ in einer z-Richtung erzeugen kann, sowie mit einer Apparatur zur Durchführung von NMR-MAS-Messungen, welche einen rotierbaren Mechanismus mit einem Stator umfasst, der einen beweglichen Rotor trägt, in welchen eine NMR-Messprobe eingefüllt werden kann, wobei sich das NMR-Spektrometer dadurch auszeichnet, dass es einen Messkopf der oben beschriebenen erfindungsgemäßen Art aufweist.

Bei einer besonders bevorzugten Verfahrensvariante zum Betrieb dieses NMR-Spektrometers wird das Verhältnis der Signale $T_i(\boldsymbol{E_i}, \boldsymbol{B}_0)$ zweier Sensoren als Regelsignal zur Einstellung oder Nachführung des Winkels $\theta$ verwendet, wobei insbesondere das Verhältnis der Ströme durch die beiden Sensoren, die Ausgestaltung der Sensoren und/oder die Winkel der Sensoren gegenüber der z-Achse so angepasst werden, dass bei $\theta = \theta_{soll}$ das Messsignal möglichst genau 1 beträgt. Ein derart gestalteter Messkopf erlaubt die Kompensation multiplikativer Abweichungen der verwendeten Sensoren.

Bei einer anderen besonders bevorzugten Verfahrensvariante wird die Differenz der Signale $T_i(\boldsymbol{E_i}, \boldsymbol{B}_0)$ zweier Sensoren als Regelsignal zur Einstellung oder Nachführung des Winkels $\theta$ verwendet, wobei insbesondere das Verhältnis der Ströme durch die beiden Sensoren, die Ausgestaltung der Sensoren und/oder die Winkel der Sensoren gegenüber der z-Achse so angepasst werden, dass bei $\theta = \theta_{soll}$ das Messsignal möglichst genau 0 beträgt. Damit wird eine möglichst geringe Empfindlichkeit der Messung von Variationen der Sensorsignale durch externe Bedingungen, die additiv zum Sensorsignal wirken, erzielt.

Bei einer weiteren besonders bevorzugten Verfahrensvariante werden mindestens zwei Gruppen von mindestens zwei Sensoren so verschaltet, dass die Summe der Verhältnisse oder das Verhältnis der Summen der Messsignale der Sensoren innerhalb jeder Gruppe der mindestens zwei Gruppen als Messsignal dient. Dadurch wird ermöglicht sowohl additive als auch multiplikative Abhängigkeiten des Messsignals von externen Parametern zu eliminieren.

Vorteilhaft ist auch eine Verfahrensvariante zum Betrieb des NMR-Spektrometers, die sich dadurch auszeichnet, dass beim Messkopf zumindest einige der Sensorelemente Hall-Sensoren aufweisen, und dass mit den Hall-Sensoren eine AC- oder Lock-in-Messung durchgeführt wird, oder dass die Hall-Sensoren mittels Spinning-Current Methode ausgelesen werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Beschreibung der Zeichnung

Die Erfindung ist in der Zeichnung dargestellt und wird anhand von Ausführungsbeispielen näher erläutert. Es zeigen:

Fig. 1   Schematische Querschnittszeichnung eines erfindungsgemäßen NMR Messkopfes mit zwei Winkelmesssensoren;

Fig. 2a   Aufsicht und Querschnittsdarstellung eines ebenen Hall-Sensors mit vier Kontakten;

Fig. 2b   Aufsicht und Querschnittsdarstellung eines vertikalen Hall-Sensors mit fünf Kontakten;

Fig. 3a   Positionierungsmöglichkeiten des ersten und zweiten Sensorelements;

Fig. 3b   Positionierungsmöglichkeiten von Gruppen von Sensorelementen; und

Fig. 4   eine schematische Querschnittszeichnung eines NMR Messkopfes gemäß Stand der Technik mit einem Hall-Sensor zur Bestimmung des Winkels der Rotationsachse zum statischen Magnetfeld, der parallel zum statischen Feld montiert ist.

Liste der Bezugszeichen und Benennungen

(1)   Stator
(2)   Luftlager
(3)   Turbine/Antrieb des Rotors
(4)   Hall-Sensor
(5)   Messprobe
(6)   Luftleitungen

(7)     erstes Sensorelement
(8)     zweites Sensorelement
(9)     Winkelmessapparatur
(RA)    Rotationsachse
(DA)    Drehachse

Referenzliste

[1] US 8,203,339 B2

[2] US-A 5,760,586

[3] Optical alignment in magic-angle NMR", G. Bodenhausen et al., J. Magn. Reson., 48 (1982), pp. 143-147 und "Optical lever for monitoring of the magic angle", E. Mihaliuk, T. Gullion, J. Magn. Reson., 223, (2012)

[4] US 8,547,099 B2

[5] US-A 4,782,375

**Patentansprüche**

1. Messkopf einer NMR-MAS-Apparatur, der im Betrieb in ein Magnetsystem eingeführt ist, das ein homogenes statisches Magnetfeld $B_0$ in einer z-Richtung erzeugt,
   wobei sich im Betrieb der NMR-MAS-Apparatur im Messkopf eine NMR-Messprobe (5) befindet, die eine Rotationsachse (RA) aufweist,
   wobei die Rotationsachse (RA) in Bezug auf die z-Achse um einen Winkel $\theta > 0$ geneigt in einer xz-Ebene liegt,
   wobei der Winkel $\theta$ durch eine Drehung um eine Drehachse (DA) parallel zur y-Achse um einen Zielwinkel $\theta_{soll}$ herum verstellt werden kann,
   wobei z = 0 als der Schnittpunkt der Rotationsachse (RA) mit der z-Achse bei eingestelltem Winkel $\theta = \theta_{soll}$ definiert ist, und wobei der Messkopf eine Winkelmessapparatur (9) mit einem ersten Sensorelement (7) umfasst, die ein vom Winkel $\theta$ abhängiges Signal $S(\theta)$ erzeugt,
   **dadurch gekennzeichnet,**
   **dass** die Winkelmessapparatur (9) mindestens ein zweites Sensorelement (8) umfasst, wobei für die Anzahl $i$ der Sensorelemente (7, 8) gilt $i \geq 2$, und wobei die Sensorelemente (7, 8) jeweils ein Sensorsignal T$i(\mathbf{E}_i, B_0)$ erzeugen, das von der Amplitude $B_0$ des statischen Magnetfeldes $B_0$ und der vektoriellen Orientierung zwischen dem Magnetfeld $B_0$ und mindestens einem Empfindlichkeitsvektor $E_i$ abhängt, wobei die Empfindlichkeitsvektoren $E_i$ so orientiert sind, dass sie beim größtmöglichen Signal $T_i^{max}$ orthogonal zum Magnetfeld $B_0$ orientiert sind, und wobei das vom Winkel $\theta$ abhängige Signal $S(\theta)$ eine Funktion $f(T_i)$ der mindestens zwei Sensorsignale $T_i(\mathbf{E}_i, B_0)$ ist,
   **dass** mindestens zwei Empfindlichkeitsvektoren $E_i$ einen Winkel $\alpha_i$ zur z-Achse aufweisen und für die Winkel $\alpha_i$ gilt: $5° < \alpha_i < 175°$,
   und **dass** mindestens zwei der Empfindlichkeitsvektoren $E_i$ einen Winkel $\beta$ zueinander aufweisen, für den gilt: $\beta > 10°$.

2. Messkopf nach Anspruch 1, **dadurch gekennzeichnet, dass** für die Winkel $\alpha_i$ gilt: $30° < \alpha_i < 60°$, vorzugsweise $\alpha_i \approx 45°$.

3. Messkopf nach Anspruch 1 oder 2, **dadurch gekennzeichnet, dass** die Sensorelemente derart montiert sind, dass die Empfindlichkeitsvektoren $E_i$ jeweils unter einem Winke! < 45°, besser < 20°, noch besser < 10° zum statischen Magnetfeld $B_0$ ausgerichtet sind.

4. Messkopf nach einem der vorhergehenden Ansprüche, **dadurch gekennzeichnet, dass** eine Vorrichtung zur automatisierten Einstellung des Winkels $\theta$ aufgrund der $i$ Sensorsignale $T_i(\mathbf{E}_i, B_0)$ vorhanden ist.

5. Messkopf nach einem der vorhergehenden Ansprüche, **dadurch gekennzeichnet, dass** mindestens zwei Gruppen von mindestens zwei Sensorelementen so verschaltet, dass die Summe der Verhältnisse der Messsignale der Sensorelemente innerhalb jeder Gruppe der mindestens zwei Gruppen als Regelsignal zur Einstellung oder Nach-

führung des Winkels $\theta$ erhalten wird.

6. Messkopf nach einem der vorhergehenden Ansprüche, **dadurch gekennzeichnet, dass** die mindestens zwei Sensorelemente (7, 8) auf einem gemeinsamen Substrat oder Träger hergestellt sind.

7. Messkopf nach einem der vorhergehenden Ansprüche, **dadurch gekennzeichnet, dass** die mindestens zwei Sensorelemente (7, 8) durch eine Verbindung mit hoher Wärmeleitfähigkeit $\lambda_1$ auf einem Stator (1) befestigt sind, der aus Material mit hoher Wärmeleitfähigkeit $\lambda_2$ gefertigt ist, wobei $\lambda_1, \lambda_2 > 30$ W/(m K), besser $\lambda_1, \lambda_2 > 100$ W/(m K), idealerweise $\lambda_1, \lambda_2 > 200$ W/(m K).

8. Messkopf nach einem der vorhergehenden Ansprüche, **dadurch gekennzeichnet, dass** zumindest einige der Sensorelemente (7, 8), vorzugsweise sämtliche Sensorelemente (7, 8), Hall-Sensoren aufweisen.

9. Messkopf nach einem der vorhergehenden Ansprüche, **dadurch gekennzeichnet, dass** zumindest einige der Sensorelemente (7, 8), vorzugsweise sämtliche Sensorelemente (7, 8), Magnetodioden oder Magnetotransistoren aufweisen.

10. Messkopf nach einem der vorhergehenden Ansprüche, **dadurch gekennzeichnet, dass** drei oder mehr Sensorelemente (7, 8) vorhanden sind, also $i \geq 3$, wobei die Sensorelemente (7, 8) bevorzugt identisch ausgeführt sind und zum Teil identische Empfindlichkeitsvektoren $\boldsymbol{E}_i$ aufweisen.

11. Messkopf nach einem der vorhergehenden Ansprüche, **dadurch gekennzeichnet, dass** mindestens zwei der Sensorelemente (7, 8) denselben Empfindlichkeitsvektor $\boldsymbol{E}_i$ aufweisen, und dass diese Sensorelemente (7, 8) orthogonal gekoppelt sind.

12. NMR-Spektrometer mit einem Magnetsystem, das ein homogenes statisches Magnetfeld $\boldsymbol{B}_0$ in einer z-Richtung erzeugen kann, sowie mit einer Apparatur zur Durchführung von NMR-MAS-Messungen, welche einen rotierbaren Mechanismus mit einem Stator (1) umfasst, der einen beweglichen Rotor trägt, in welchen eine NMR-Messprobe (5) eingefüllt werden kann, **dadurch gekennzeichnet, dass** das NMR-Spektrometer einen Messkopf nach einem der vorhergehenden Ansprüche aufweist.

## Claims

1. A measuring head of an NMR-MAS apparatus, which is introduced in operation in a magnet system, which generates a homogeneous static magnetic field $\boldsymbol{B}_0$ in a z-direction,
   wherein, in operation of the NMR-MAS apparatus, an NMR measurement sample (5) is present in the measuring head, which has a rotation axis (RA),
   wherein the rotation axis (RA) is tilted at an angle $\theta > 0$ with respect to the z-axis, lies in an xz-plane, wherein the angle $\theta$ can be adjusted by tilting around a tilt axis (DA) parallel to the y-axis around a target angle $\theta_{target}$,
   wherein z = 0 is defined as the intersection point of the rotation axis (RA) with the z-axis with the adjusted angle $\theta = \theta_{target}$,
   and wherein the measuring head comprises an angle measurement apparatus (9) with a first sensor element (7), which generates a signal $S(\theta)$ dependent on the angle $\theta$,
   **characterized in that**
   the angle measurement apparatus (9) comprises at least a second sensor element (8), wherein the number $i$ of the sensor elements (7, 8) is $i \geq 2$, and wherein the sensor elements (7, 8) generate a sensor signal $T_i(\boldsymbol{E}_i, \boldsymbol{B}_0)$ each, which depends on the amplitude $B_0$ of the static magnetic field $\boldsymbol{B}_0$ and the vectorial orientation between the magnetic field $\boldsymbol{B}_0$ and at least one sensitivity vector $\boldsymbol{E}_i$, wherein the sensitivity vectors $E_i$ are oriented such that they are oriented orthogonal to the magnetic field $\boldsymbol{B}_0$ at the highest possible signal $T_i^{max}$, and wherein the signal $S(\theta)$ depending on the angle $\theta$ is a function $f(T_i)$ of the at least two sensor signals $T_i(\boldsymbol{E}_i, \boldsymbol{B}_0)$,
   that at least two sensitivity vectors $\boldsymbol{E}_i$ have an angle $\alpha_i$ to the z-axis, and the following applies to the angles $\alpha_i$: $5° < \alpha_i < 175°$,
   and that at least two of the sensitivity vectors $\boldsymbol{E}_i$ have an angle $\beta$ to each other, for which applies: $\beta > 10°$.

2. The measuring head according to claim 1, **characterized in that** the following applies to the angles $\alpha_i$: $30° < \alpha_i < 60°$, preferably $\alpha_i \approx 45°$.

3. The measuring head according to claim 1 or 2, **characterized in that** the sensor elements are mounted in such a manner that the sensitivity vectors $E_i$ are each oriented at an angle < 45°, better < 20°, even better < 10°, to the static magnetic field $B_0$.

4. The measuring head according to any of the preceding claims, **characterized in that** a device for automated adjustment of the angle $\theta$ based on the $i$ sensor signals $T_i(E_i, B_0)$ is available.

5. The measuring head according to any of the preceding claims, **characterized in that** at least two groups of at least two sensor elements are interconnected in such a way that the total of the ratios of the measurement signals of the sensor elements within each group of the at least two groups is obtained as a regulating signal for adjusting or tracking the angle $\theta$.

6. The measuring head according to any of the preceding claims, **characterized in that** the at least two sensor elements (7, 8) are manufactured on a shared substrate or carrier.

7. The measuring head according to any of the preceding claims, **characterized in that** the at least two sensor elements (7, 8) are attached to a stator (1), which is manufactured from a material with a high thermal conductivity $\lambda_2$ by means of a connection with a high thermal conductivity $\lambda_1$, wherein $\lambda_1, \lambda_2$ > 30W/(m K), better $\lambda_1, \lambda_2$ > 100W/(m K), ideally $\lambda_1, \lambda_2$ > 200W/(m K).

8. The measuring head according to any of the preceding claims, **characterized in that** at least some of the sensor elements (7, 8), preferably all sensor elements (7, 8), have Hall sensors.

9. The measuring head according to any of the preceding claims, **characterized in that** at least some of the sensor elements (7, 8), preferably all sensor elements (7, 8), have magnetodiodes or magnetotransistors.

10. The measuring head according to any of the preceding claims, **characterized in that** three or more sensor elements (7, 8) are available,
i.e. $i \geq 3$, wherein the sensor elements (7, 8) preferably have an identical design and have partly identical sensitivity vectors $E_i$.

11. The measuring head according to any of the preceding claims, **characterized in that** at least two of the sensor elements (7, 8) have the same sensitivity vector $E_i$, and that these sensor elements (7, 8) are coupled orthogonally.

12. An NMR spectrometer with a magnet system, which can generate a homogeneous static magnetic field $B_0$ in a $z$-direction, and with an apparatus for carrying out NMR-MAS measurements, which comprises a rotatable mechanism with a stator (1) carrying a movable rotor, in which an NMR measurement sample (5) can be filled, **characterized in that** the NMR spectrometer has a measuring head according to any of the preceding claims.

**Revendications**

1. Tête de mesure d'un appareil RMN-MAS qui est introduite pendant le fonctionnement dans un système magnétique qui génère un champ magnétique statique homogène $B_0$ dans une direction z,
dans laquelle, pendant le fonctionnement de l'appareil RMN-MAS, un échantillon de mesure RMN (5) qui présente un axe de rotation (RA) se trouve dans la tête de mesure, l'axe de rotation (RA) étant incliné par rapport à l'axe z d'un angle $\theta$ > 0 et situé dans un plan $xz$, l'angle $\theta$ pouvant être réglé autour d'un angle cible $\theta_{soll}$ par une rotation autour d'un axe de rotation (DA) parallèle à l'axe $y$,
dans laquelle $z$ = 0 est défini comme le point d'intersection de l'axe de rotation (RA) avec l'axe z lorsque l'angle $\theta$ est réglé à $\theta = \theta_{soll}$,
et dans laquelle la tête de mesure comprend un dispositif de mesure d'angle (9) avec un premier élément capteur (7) qui génère un signal S($\theta$) dépendant de l'angle $\theta$,
**caractérisé en ce**
**que** le dispositif de mesure d'angle (9) comprend au moins un deuxième élément capteur (8), le nombre $i$ d'éléments capteurs (7, 8) étant tel que $i \geq 2$, et les éléments capteurs (7, 8) générant chacun un signal de capteur $T_i(E_i, B_0)$ qui dépend de l'amplitude $B_0$ du champ magnétique statique $B_0$ et de l'orientation vectorielle entre le champ magnétique $B_0$ et au moins un vecteur de sensibilité $E_i$, les vecteurs de sensibilité $E_i$ étant orientés de telle sorte qu'ils sont orientés orthogonalement au champ magnétique $B_0$ au plus grand signal $T_i^{max}$ possible, et le signal S($\theta$)

dépendant de l'angle $\theta$ étant une fonction $f(T_i)$ desdits au moins deux signaux de capteur $T_i(\boldsymbol{E_i}, \boldsymbol{B_0})$,

**qu'**au moins deux vecteurs de sensibilité $\boldsymbol{E_i}$ présentent un angle $\alpha_i$ par rapport à l'axe $z$ et que les angles $\alpha_i$ sont tels que : $5° < \alpha_i < 175°$,

et **qu'**au moins deux des vecteurs de sensibilité $\boldsymbol{E_i}$ présentent entre eux un angle $\beta$ auquel s'applique : $\beta > 10°$.

2. Tête de mesure selon la revendication 1, **caractérisée en ce que** les angles $\alpha_i$ sont tels que : $30° < \alpha_i < 60°$, de préférence $\alpha_i \approx 45°$.

3. Tête de mesure selon la revendication 1 ou 2, **caractérisée en ce que** les éléments capteurs sont montés de telle sorte que les vecteurs de sensibilité $\boldsymbol{E_i}$ sont orientés chacun selon un angle < 45°, mieux < 20°, encore mieux < 10° par rapport au champ magnétique statique $\boldsymbol{B_0}$.

4. Tête de mesure selon l'une des revendications précédentes, **caractérisée en ce qu'**un dispositif est prévu pour le réglage automatisé de l'angle $\theta$ sur la base des $i$ signaux de capteur $T_i(\boldsymbol{E_i}, \boldsymbol{B_0})$.

5. Tête de mesure selon l'une des revendications précédentes, **caractérisée en ce qu'**au moins deux groupes d'au moins deux éléments capteurs sont connectés de telle sorte que la somme des rapports des signaux de mesure des éléments capteurs à l'intérieur de chaque groupe desdits au moins deux groupes est obtenue comme signal de régulation pour régler ou asservir l'angle $\theta$.

6. Tête de mesure selon l'une des revendications précédentes, **caractérisée en ce que** lesdits au moins deux éléments capteurs (7, 8) sont fabriqués sur un substrat ou support commun.

7. Tête de mesure selon l'une des revendications précédentes, **caractérisée en ce que** lesdits au moins deux éléments capteurs (7, 8) sont fixés par une liaison à haute conductivité thermique $\lambda_1$ sur un stator (1) qui est réalisé dans un matériau à haute conductivité thermique $\lambda_2$, avec $\lambda_1, \lambda_2 > 30$ W/(m K), mieux $\lambda_1, \lambda_2 > 100$ W/(m K), idéalement $\lambda_1, \lambda_2 > 200$ W/(m K).

8. Tête de mesure selon l'une des revendications précédentes, **caractérisée en ce qu'**au moins certains des éléments capteurs (7, 8), de préférence tous les éléments capteurs (7, 8), présentent des capteurs à effet Hall.

9. Tête de mesure selon l'une des revendications précédentes, **caractérisée en ce qu'**au moins certains des éléments capteurs (7, 8), de préférence tous les éléments capteurs (7, 8), présentent des magnétodiodes ou des magnétotransistors.

10. Tête de mesure selon l'une des revendications précédentes, **caractérisée en ce que** trois éléments capteurs (7, 8) ou plus sont présents, c'est-à-dire $i \geq 3$, les éléments capteurs (7, 8) étant de préférence de réalisation identique et présentant en partie des vecteurs de sensibilité $\boldsymbol{E_i}$ identiques.

11. Tête de mesure selon l'une des revendications précédentes, **caractérisée en ce qu'**au moins deux des éléments capteurs (7, 8) présentent le même vecteur de sensibilité $\boldsymbol{E_i}$, et que ces éléments capteurs (7, 8) sont couplés orthogonalement.

12. Spectromètre RMN comprenant un système magnétique capable de générer un champ magnétique statique homogène $\boldsymbol{B_0}$ dans une direction $z$ et un appareil pour effectuer des mesures RMN-MAS, lequel comprend un mécanisme rotatif avec un stator (1) qui porte un rotor mobile dans lequel un échantillon de mesure RMN (5) peut être introduit, **caractérisé en ce que** le spectromètre RMN présente une tête de mesure selon l'une des revendications précédentes.

**Fig. 1**

**Fig. 2a**

**Fig. 2b**

**Fig. 3a**

**Fig. 3b**

PRIOR ART

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8203339 B2
- US 8547099 B2
- US 5760586 A
- US 4782375 A

**In der Beschreibung aufgeführte Nicht-Patentliteratur**

- **G. BODENHAUSEN et al.** Optical alignment in magic-angle NMR. *J. Magn. Reson.,* 1982, vol. 48, 143-147
- **E. MIHALIUK ; T. GULLION.** Optical lever for monitoring of the magic angle. *J. Magn. Reson.,* 2012, vol. 223, 46-50
- **E. MIHALIUK ; T. GULLION.** Optical lever for monitoring of the magic angle. *J. Magn. Reson.,* 2012, 223